Europäisches Patentamt

European Patent Office

Office européen des brevets

(19)

(11) Numéro de publication : **0 488 864 B1**

(12) **FASCICULE DE BREVET EUROPEEN**

(45) Date de publication du fascicule du brevet :
06.09.95 Bulletin 95/36

(51) Int. Cl.[6] : **H01L 31/0352**

(21) Numéro de dépôt : **91403159.6**

(22) Date de dépôt : **22.11.91**

(54) **Bolomètre électronique à puits quantique et application à un détecteur de rayonnements.**

(30) Priorité : **29.11.90 FR 9014924**

(43) Date de publication de la demande :
**03.06.92 Bulletin 92/23**

(45) Mention de la délivrance du brevet :
**06.09.95 Bulletin 95/36**

(84) Etats contractants désignés :
**DE GB**

(56) Documents cités :
**US-A- 4 745 452
PATENT ABSTRACTS OF JAPAN vol. 11, no. 117 (E-498) 11 avril 1987 & JP-A-61 263 287
PATENT ABSTRACTS OF JAPAN vol. 9, no. 204 (E-337) 21 août 1985 & JP-A-60 066 878
REVUE DE PHYSIQUE APPLIQUEE, vol. 24, no. 1, janvier 1989, PARIS, FR; pages 37-43; F.H. JULIEN et al.: 'NON-LINEARITES D'ABSORPTION INTRABANDE DANS LES PUITS QUANTIQUES GaAs-A1(x)Ga(1-x)As'**

(56) Documents cités :
**APPLIED PHYSICS LETTERS, vol. 53, no. 4, 25 juillet 1988, New York, US; pages 296-298; B.F. LEVINE ET AL.: 'HIGH DETECTIVITY D$^*$ = 1.0 x 10 cm VHz/W GaAs/AlGaAs MULTIQUANTUM WELL LAMBDA = 8.3 MICROMETERS INFRA-RED DETECTOR'
SOVIET PHYSICS SEMICONDUCTORS, vol. 22, no. 12, décembre 1988, New York, US; pages 1346-1350; O.G. KONDRAT'EVA ET AL.: 'TRANSVERSE CONDUCTIVITY OF A DOPED SUPERLATTICE'**

(73) Titulaire : **THOMSON-CSF
173, Boulevard Haussmann
F-75008 Paris (FR)**

(72) Inventeur : **Rosencher, Emmannuel
THOMSON-CSF,
SCPI,
Cédex 67
F-92045 Paris la Défense (FR)**
Inventeur : **Bois, Philippe
THOMSON-CSF,
SCPI,
Cédex 67
F-92045 Paris la Défense (FR)**

(74) Mandataire : **Guérin, Michel et al
THOMSON-CSF
SCPI
B.P. 329
50, rue Jean-Pierre Timbaud
F-92402 Courbevoie Cédex (FR)**

EP 0 488 864 B1

## Description

L'invention concerne un bolomètre électronique à puits quantique et son application à un détecteur d'ondes électromagnétiques, plus particulièrement un détecteur d'ondes à semiconducteur à puits quantiques. Ce détecteur fonctionne comme un bolomètre à électrons chauds qui permet, par rapport aux dispositifs connus utilisant des puits quantiques, de détecter des ondes en incidence normale.

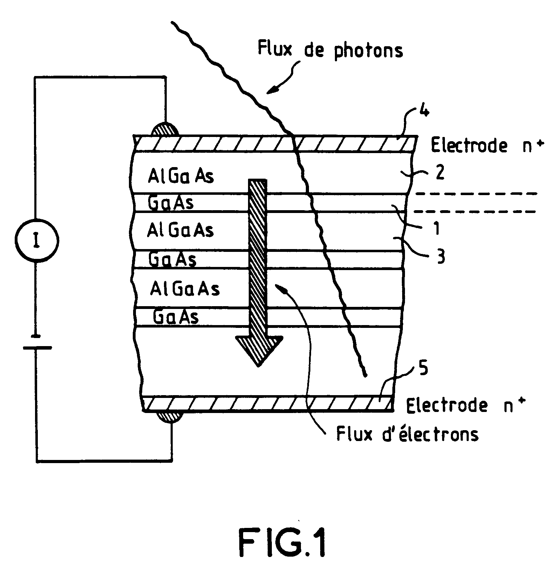

Par exemple, le document de B. F. LEVINE et al publié dans Applied Physics Letters n° 53, 296 de 1988 décrit un photoconducteur à puits quantiques comportant comme cela est représenté en figure 1 un empilement de puits quantiques constitués chacun d'une couche de GaAs (telle que la couche 1) encadrée par deux couches de AlGaAs (telles que les couches 2 et 3). Des électrodes 4 et 5 sont prévues à la partie supérieure et à la partie inférieure de l'empilement de couches. Dans un tel dispositif, les électrons sont stockés sur leur niveau quantique dans le puits quantique de GaAs. Sous éclairement, ces électrons sont excités dans la bande de conduction de la barrière de potentiel (AlGaAs) et sont collectés dans les contacts ohmiques (électrodes 4 et 5) situés de part et d'autre de l'empilement des puits quantiques.

Ce type de détecteur présente deux inconvénients :

1- En régime photoconducteur, le courant est indépendant du nombre de puits à champ électrique constant. Un seul puits peut détecter la lumière, la structure se repolarisant pour garder ce courant dans le détecteur. Ceci provient du fait que dans ce détecteur, le flux de photons est parallèle au flux d'électrons.

2 - Le mouvement des électrons n'étant quantifié que dans la direction de croissance, seule la composante normale aux puits quantiques du champ électromagnétique interne est détectée. Ainsi, ce dispositif ne détecte pas les ondes incidentes normales à la surface, ce qui rend leur intégration dans des systèmes matriciels très difficile comme cela est décrit dans les documents :

. K.W. GOOSEN and S.A. LYON, Applied Physics Letters 53, 1027 (1988)
. G. HASNAM, B.F. LEVINE, C.G. BETHEA, R.A. LOGAN, J. WALKER and R.J. MOLIK, Applied Physics Letters 54, 2515 (1989).

Le premier inconvénient a trouvé une solution dans la Demande de Brevet FR-A-2662855, déposée le 5 juin 1990 (E. ROSENCHER et B. VINTER) en adoptant une géométrie des contacts ohmiques transverses. Le dispositif décrit dans cette Demande de Brevet comporte au moins un premier puits quantique et un deuxième puits quantique non dopé, un transfert d'électrons du premier puits vers le deuxième puits étant possible sous l'effet d'un rayonnement incident de façon oblique par rapport au plan des puits quantiques. Le détecteur comporte en outre des contacts ohmiques situés latéralement par rapport aux deux puits quantiques.

Le deuxième inconvénient est remédié par la présente invention. L'idée de base de l'invention est d'utiliser un phénomène physique qui ne soit pas sensible à la polarisation de la lumière : la bolométrie d'électrons chauds.

L'invention concerne donc un bolomètre électronique à puits quantique, caractérisé en ce qu'il comporte :

- un empilement de couches de semiconducteurs réalisant au moins un puits quantique compris entre deux couches barrières et possédant une face d'entrée parallèle auxdites couches destinée à recevoir un faisceau d'éclairement selon un angle d'incidence par rapport à la normale compris entre 0 et 80 degrés, le puits quantique étant dopé et possédant au moins un premier niveau d'énergie permis $E_1$ tel que l'énergie correspondant à la longueur d'onde du faisceau d'éclairement corresponde à une énergie de valeur $E_{CB} - E_1$, $E_{CB}$ étant l'énergie du bas de la bande de conduction ou du haut de la bande de valence des couches barrières ;

- au moins deux électrodes situées sur deux parties latérales opposées de l'empilement de couches formant des contacts ohmiques avec les couches constituant les puits quantiques.

L'invention concerne également un détecteur de rayonnements à semiconducteurs, caractérisé en ce qu'il comporte un bolomètre destiné à être éclairé par un rayonnement à détecter selon un angle d'incidence voisin de l'incidence normale.

Les différents objets et caractéristiques de l'invention apparaîtront dans la description qui va suivre et dans les dessins annexés qui représentent :

- la figure 1, un dispositif connu décrit précédemment ;
- les figures 2a et 2b, un schéma simplifié du dispositif de l'invention ;
- les figures 3a et 3b, un schéma de fonctionnement détaillé du dispositif de l'invention ;
- les figures 4a et 4b, un exemple de réalisation détaillée du dispositif de l'invention ;
- la figure 5 représente la photo-réponse d'un tel détecteur selon l'invention.

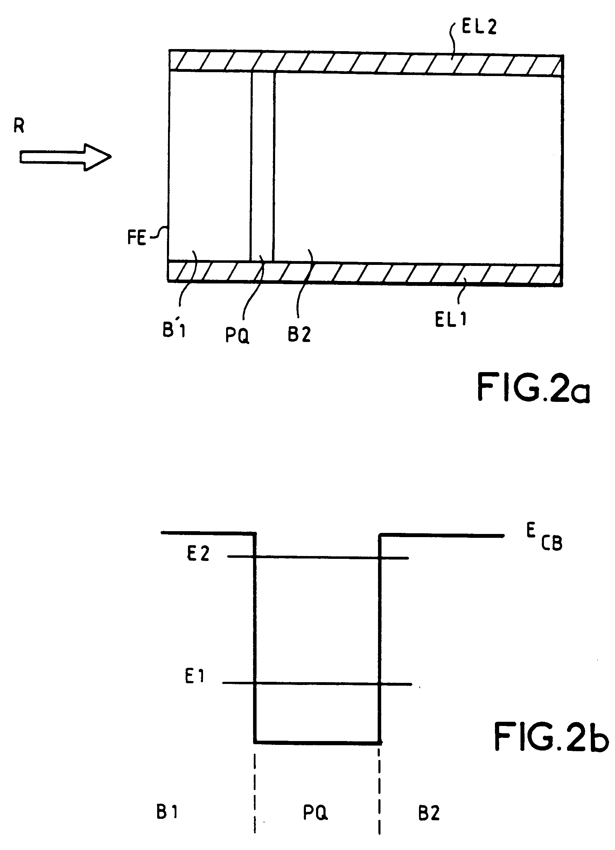

Le dispositif de l'invention représenté de façon schématique en figure 2a comporte un empilement de couches B1, PQ, B2. La couche PQ est un matériau semiconducteur peuplé en porteurs et constitue un puits quantique. Les couches B1 et B2 constituant les barrières du puits quantique. Des électrodes EL1, EL2 sont disposées sur deux tranches opposées du dispositif perpendiculaire aux plans des couches B1, PQ, B2.

Une telle structure présente un profil de bande de conduction tel que représenté en figure 2b. Le dimensionnement des puits est tel que la différence entre les deux premiers niveaux d'énergie E2 - E1 ou $E_{CB}$ - E1 corresponde à l'énergie de l'onde électromagnétique à détecter. Bien entendu, cette structure peut être réalisée aussi bien avec des électrons qu'avec des trous, désignés sous le terme "porteurs" dans ce qui va suivre.

Le phénomène bolométrique s'appuie sur la variation de conductivité des porteurs en fonction de leur température électronique Te, c'est-à-dire de leur énergie dans leur état excité par rapport à leur état fondamental. En obscurité, cette température électronique dépend du champ électrique appliqué E. La conductivité σ des puits quantiques en obscurité est alors donnée par :

$$\sigma\,(Te) = \sigma\,(E) = \sigma\,o\,(1 + \beta\,E^2) \quad (1)$$

où σ o est la conductivité à faible champ et β le coefficient de non-linéarité.

La puissance lumineuse absorbée par les porteurs de la sous-bande (effet Drude) est convertie en température électronique ΔTe. En d'autres termes, le gaz électronique est chauffé, provoquant une photoconductivité Δσ (équation 1). KOGHAN (voir documents : SH. M. KOGAN, Soviet Physics-Solid State, 4, 1386 (1963)) a montré que, dans les matériaux massifs InSb, la réponse en V/W associée à cet effet bolométrique $\Delta V/P_{absorb\acute{e}e}$ est donnée par :

$$R = \eta\,\frac{1}{S\sigma} \cdot \frac{\beta E}{1 + 2\beta E^2} \quad (2)$$

où η est le pourcentage d'énergie absorbée et S la surface éclairée. Dans le cas des puits quantiques, la quantification des énergies des porteurs conduit à une augmentation résonnante de l'absorption de la lumière.

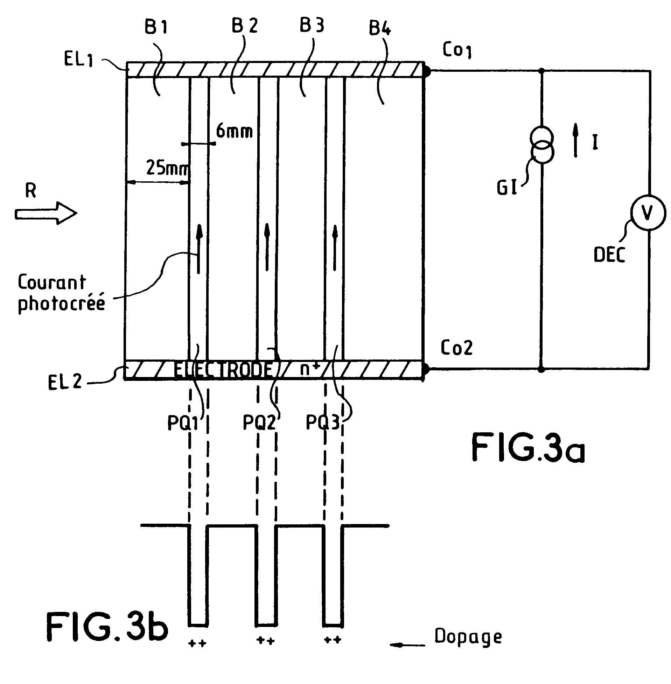

La figure 3a représente un exemple pratique de réalisation. Il s'agit d'un empilement :
- des puits quantiques PQ1, PQ2, PQ3 de GaAs dopé à $5 \times 10^{11}$ cm$^{-2}$ d'épaisseur égale à 6 nm,
- des barrières de potentiel B1, B2, B3, B4... entourant les puits quantiques, de 25 nm d'épaisseur en $Al_{0,24}$, $Ga_{0,76}$, As.

Le tout est épitaxié par tout moyen de l'art sur un substrat de GaAs semi-isolant. Les épaisseurs et les compositions des couches sont calculées pour obtenir une transition résonnante à 10.6 μm.

La figure 3b représente le profil de potentiels de la bande de conduction de cette structure, mais on aurait pu représenter le profil potentiel de la bande de valence.

En ce qui concerne le détecteur lui-même, des dimensions latérales de 100 x 100 micromètres, à titre d'exemple, conviendront. Les contacts ohmiques latéraux pourront être obtenus par diffusion d'indium, par exemple. En ce qui concerne la détection du courant, un génératuer de courant G1 peut être connecté aux bornes EL1 et EL2 du dispositif et la variation de potentiel mesurée par un détecteur synchrone DEC ou tout autre montage électronique de l'art.

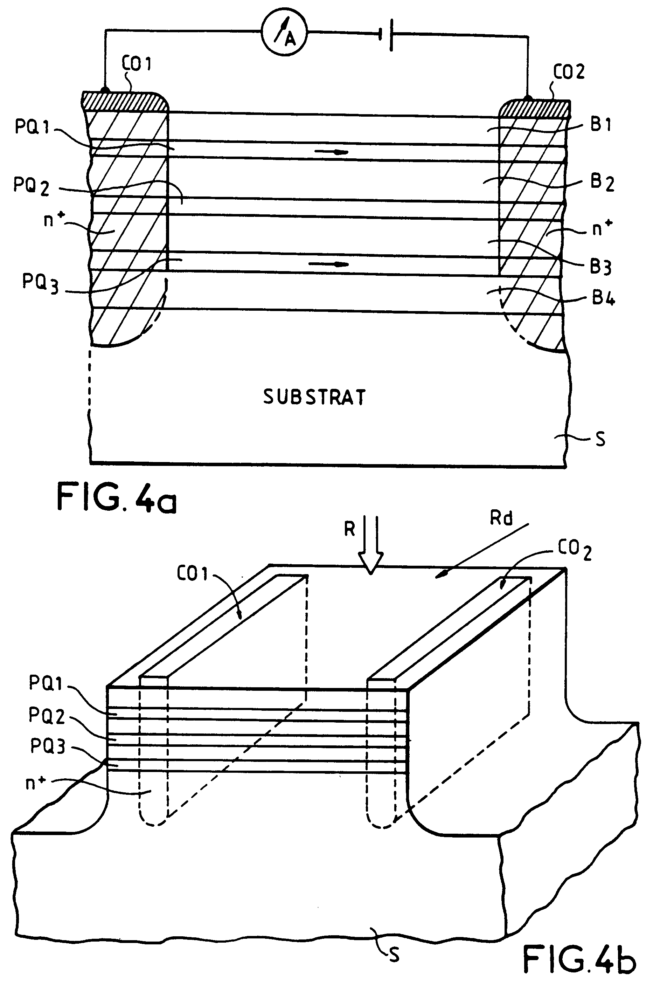

En se reportant aux figures 4a et 4b, on va maintenant décrire un exemple de réalisation détaillé du dispositif de l'invention.

Le dispositif comporte, un substrat en GaAs semi-isolant, une alternance de couches formant des puits quantiques PQ1, PQ2, PQ3 et de couches barrières B1 à B4.

Dans ces couches sont réalisées des diffusions ou des implantations de type n$^+$ de façon à réaliser des contacts ohmiques avec des connexions CO1 et CO2.

La figure 4b réprésnte en perspective la structure de la figure 4a.

Les différentes couches du dispositif peuvent être réalisées en GaAs et AlGaAs comme cela a été décrit précédemment.

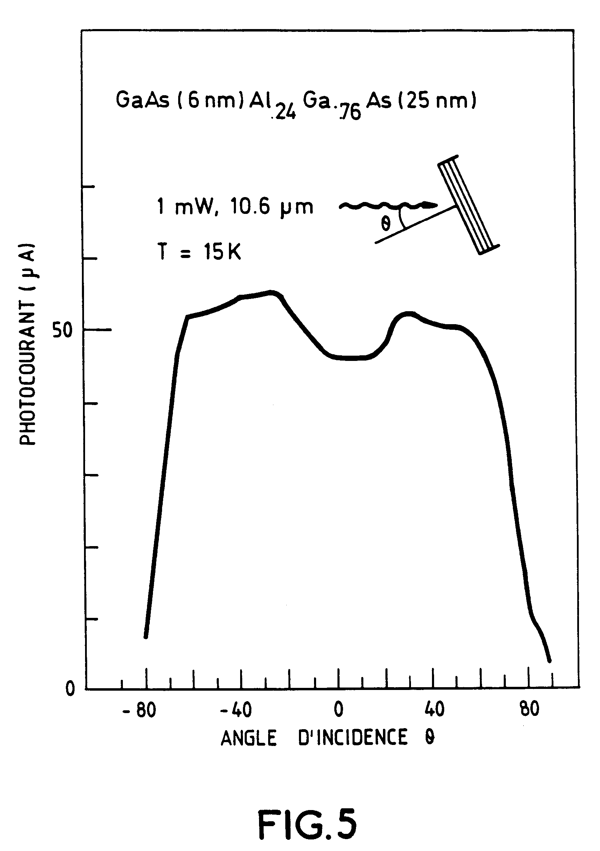

La figure 5 représente des résultats d'essais de fonctionnement obtenus à l'aide d'une structure selon l'invention. Il s'agit de la réponse d'un détecteur à 15K sous une irradiation laser de 1 mW à une longueur d'onde de 1.0,6 μm en fonction de l'angle d'incidence θ . On constate que le composant détecte bien à incidence normale contrairement aux dispositifs connus avec une réponse de 0,05 A/W à 15K.

Il est à noter que, dans ce qui précède, le peuplement en porteurs, par exemple en électrons, du puits quantique est réalisé par dopage direct du puits. On prévoit également que ce peuplement en électrons se fait à l'aide d'un rayonnement Rd représenté sur la figure 4a (alors que le rayonnement à détecter est représenté par R). La caractéristique de ce rayonnement Rd doit être telle que sa longueur d'onde corresponde à une énergie supérieure à l'énergie de confinement du puits quantique c'est-à-dire supérieure à Eg + E1 + Ehh$_1$
où :

Eg est la largeur de bande interdite de la couche de puis quantique

E1 est le premier niveau quantifié en électrons du puits quantique

Ehh$_1$ est le premier niveau quantifié en trous du puits quantique.

Dans les exemples de réalisation des figures 3a et 4a on considère à priori une détection d'un faisceau d'une seule longueur d'onde. Cependant la structure de l'invention est applicable à la détection de plusieurs longueurs d'ondes. Pour cela, on prévoit des puits PQ1, PQ2, PQ3 de caractéristiques différentes. Notamment, on peut prévoir ries puits de largeurs différentes.

Par ailleurs, le dispositif de l'invention peut être réalisé sous forme d'une barrette ou d'une matrice par implantation d'électrodes dans une même plaque. Chaque élément de la barrette ou de la matrice pouvant être lu individuellement. Le fonctionnement a incidence normale du dispositif de l'invention permet une intégration et un fonctionnement sous forme matricielle.

Il est bien évident que la description qui précède n'a été faite qu'à titre d'exemple. Les exemples numériques et de matériaux (Arsenic et Gallium par exemple) notamment n'ont été fournis que pour illustrer la description.

## Revendications

1. Bolomètre électronique à puits quantique, caractérisé en ce qu'il comporte :
   - un empilement de couches de semiconducteurs (B1, PQ, B2) réalisant au moins un puits quantique (PQ) compris entre deux couches barrières (B1, B2) et possédant une face d'entrée (FE) parallèle auxdites couches destinée à recevoir un faisceau d'éclairement (R) selon un angle d'incidence par rapport à la normale compris entre 0 et 80 degrés, le puits quantique étant dopé et possédant au moins un premier niveau d'énergie permis E1 tel que l'énergie correspondant à la longueur d'onde du faisceau d'éclairement corresponde à une énergie de valeur $E_{CB}$ - E1, $E_{CB}$ étant l'énergie du bas de la bande de conduction, ou du haut de la bande de valence, des couches barrières ;
   - au moins deux électrodes situées sur deux parties latérales opposées de l'empilement de couches formant des contacts ohmiques avec les couches constituant les puits quantiques.

2. Bolomètre selon la revendication 1, caractérisé en ce que l'angle d'incidence peut être voisin de 0 degré.

3. Bolomètre selon la revendication 1, caractérisé en ce que le dopage du puits quantique est un dopage direct de la couche du puits quantique et/ou un dopage modulé des barrières.

4. Bolomètre selon la revendication 1, caractérisé en ce que le puits quantique comporte un deuxième niveau permis de niveau E2 dont la valeur est telle que la longueur d'onde du faisceau d'éclairement corresponde à une énergie de valeur E2 - E1.

5. Bolomètre selon la revendication 1, caractérisé en ce qu'il comporte un empilement de puits quantiques.

6. Bolomètre selon la revendication 1, caractérisé en ce qu'il comporte des circuits de mesure de conductivité connectés aux électrodes (EL1, EL2).

7. Détecteur de rayonnements à semiconducteurs, caractérisé en ce qu'il comporte un bolomètre selon l'une des revendications précédentes, destiné à être éclairé par un rayonnement à détecter selon un angle d'incidence voisin de l'incidence normale à la face d'entrée (FE).

8. Détecteur de rayonnements à semiconducteurs selon la revendication 7, caractérisé en ce qu'il comprend un arrangement de bolomètres en barrettes, ou en matrice.

9. Détecteur de rayonnements à semiconducteurs selon la revendication 7, caractérisé en ce qu'il comporte un empilement de plusieurs puits quantiques de caractéristiques différentes.

10. Détecteur de rayonnement à semiconducteurs selon la revendication 9, caractérisé en ce que les épaisseurs des couches de puits quantiques sont différentes de façon à ce que chaque puits permette de détecter une longueur d'onde particulière.

## Patentansprüche

1. Elektronisches Bolometer mit Quantensenke, dadurch gekennzeichnet, daß es aufweist:
   - eine Stapelung von Halbleiterschichten (B1, PQ, B2), die mindestens eine zwischen zwei Barriereschichten (B1, B2) eingeschlossene Quantensenke (PQ) bilden, wobei eine Strahlungs-Eintrittsfläche (FE) parallel zu den Schichten vorgesehen ist und eine Strahlung (R) gemäß einem Auftreffwinkel bezüglich der Senkrechten zwischen 0 und 80° empfängt, wobei die Quantensenke dotiert ist und mindestens ein erstes erlaubtes Energieniveau E1 derart besitzt, daß die Energie entsprechend der Wellenlänge der Strahlung einer Energie des Werts $E_{CB}$-E1 entspricht, wobei $E_{CB}$ die Energie am unteren Ende des Leitbandes oder am oberen Ende des Valenzbandes der Barriereschichten ist,
   - mindestens zwei Elektroden auf den beiden einander gegenüberliegenden Seitenbereichen der Stapelung von Schichten, wobei diese Elektroden ohm'sche Kontakte mit den die Quantensenken darstellenden Schichten bilden.

2. Bolometer nach Anspruch 1, dadurch gekennzeichnet, daß der Einfallswinkel nahe bei 0° liegen kann.

3. Bolometer nach Anspruch 1, dadurch gekennzeichnet, daß die Dotierung der Quantensenke eine direkte Dotierung der Quantensenkenschicht und/oder eine modulierte Dotierung der Barrieren ist.

4. Bolometer nach Anspruch 1, dadurch gekennzeichnet, daß die Quantensenke ein zweites erlaubtes Niveau E2 aufweist, dessen Wert so gewählt ist, daß die Wellenlänge der Strahlung einer Energie des Werts E2-E1 entspricht.

5. Bolometer nach Anspruch 1, dadurch gekennzeichnet, daß es eine Stapelung von Quantensenken enthält.

6. Bolometer nach Anspruch 1, dadurch gekennzeichnet, daß es Schaltungen zur Messung des Leitwerts enthält, die an die Elektroden (EL1, EL2) angeschlossen sind.

7. Halbleiter-Strahlungsdetektor, dadurch gekennzeichnet, daß er ein Bolometer nach einem der vorhergehenden Ansprüche enthält, das von einer zu erfassenden Strahlung unter einem Einfallswinkel in der Nähe des senkrechten Einfalls auf die Eingangsseite (FE) bestrahlt wird.

8. Halbleiter-Strahlungsdetektor nach Anspruch 7, dadurch gekennzeichnet, daß er eine Mehrzahl von in Leistenform oder Matrixform angeordneten Bolometern enthält.

9. Halbleiter-Strahlungsdetektor nach Anspruch 7, dadurch gekennzeichnet, daß er eine Stapelung von mehreren Quantensenken unterschiedlicher Merkmale enthält.

10. Halbleiter-Strahlungsdetektor nach Anspruch 9, dadurch gekennzeichnet, daß die Dicken der Schichten von Quantensenken unterschiedlich sind, so daß jede Senke eine bestimmte Wellenlänge erfassen kann.

**Claims**

1. Quantum-well electronic bolometer, characterized in that it comprises:
   - a stack of semiconductor layers (B1, QW, B2) producing at least one quantum well (QW) lying between two barrier layers (B1, B2) and possessing an entry face (EF) parallel to the said layers and intended to receive an illuminating beam (R) at an angle of incidence with respect to the normal lying between 0 and 80 degrees, the quantum well being doped and possessing at least a first allowed energy level E1 such that the energy corresponding to the wavelength of the illuminating beam corresponds to an energy of value $E_{CB}$-E1, $E_{CB}$ being the energy of the bottom of the conduction band, or of the top of the valence band, of the barrier layers;
   - at least two electrodes located on two opposite end parts of the stack of layers forming ohmic contacts with the layers constituting the quantum wells.

2. Bolometer according to Claim 1, characterized in that the angle of incidence may be close to 0 degrees.

3. Bolometer according to Claim 1, characterized in that the quantum-well doping is a direct doping of the quantum-well layer and/or a modulated doping of the barriers.

4. Bolometer according to Claim 1, characterized in that the quantum well comprises a second allowed energy level E2 whose value is such that the wavelength of the illuminating beam corresponds to an energy of value E2-E1.

5. Bolometer according to Claim 1, characterized in that it comprises a stack of quantum wells.

6. Bolometer according to Claim 1, characterized in that it comprises conductivity-measurement circuits connected to the electrodes (EL1, EL2).

7. Semiconductor radiation detector, characterized in that it comprises a bolometer according to one of the preceding claims, intended to be illuminated by radiation to be detected at an angle of incidence close to incidence normal to the entry face (EF).

8. Semiconductor radiation detector according to Claim 7, characterized in that it includes an arrangement of bolometers in a linear array or in a matrix.

9. Semiconductor radiation detector according to Claim 7, characterized in that it comprises a stack of several quantum wells of different characteristics.

10. Semiconductor radiation detector according to Claim 9, characterized in that the thicknesses of the quantum-well layers are different, so that each well allows detection of a particular wavelength.

**FIG.1**

FIG.2a

FIG.2b

FIG.3a

FIG.3b

EP 0 488 864 B1

FIG. 4a

FIG. 4b

**FIG.5**